Europäisches Patentamt

European Patent Office

Office européen des brevets

(19)

(11) Publication number: **0 259 616**
**A1**

## (12) EUROPEAN PATENT APPLICATION

(21) Application number: **87111395.7**

(22) Date of filing: **06.08.87**

(51) Int. Cl.⁴: **H01L 21/285** , H01L 21/265

(30) Priority: **12.09.86 US 906717**

(43) Date of publication of application:
**16.03.88 Bulletin 88/11**

(84) Designated Contracting States:
**DE FR GB IT**

(71) Applicant: **International Business Machines
Corporation
Old Orchard Road
Armonk, N.Y. 10504(US)**

(72) Inventor: **Oehrlein, Gottlieb Stefan
2614 Ridge Street
Yorktown Heights New York 10598(US)**
Inventor: **van Vechten, James Alden
321 Northwest 31st Street
Corvallis Oregon 97330(US)**

(74) Representative: **Mönig, Anton, Dipl.-Ing.
IBM Deutschland GmbH Schönaicher
Strasse 220
D-7030 Böblingen(DE)**

(54) **Silicon semiconductor device structure and process for forming same.**

(57) An intermediate manufacturing product adapted for fabrication into transistor or diode structures comprising a silicon monocrystalline substrate (8) provided with at least one surface which includes a masked electrical insulating silicon-containing compound layer (2) and an unmasked metal silicide layer (6) for contact purposes. A process for forming this product comprises the steps of masking portions of a silicon-containing compound layer (2) provided on at least one surface of the crystal; implanting metal ions into the interface (5) between the silicon-containing compound layer and the silicon substrate below the unmasked silicon-containing compound layer; heating the crystal to a temperature of between about 100 °C and 500 °C to form a metal silicide in regions where the metal ions were sputtered into the crystal; and anisotropically dry etching the unmasked silicon-containing compound layer above the metal silicide.

FIG.2

FIG.3

## SILICON SEMICONDUTOR DEVICE STRUCTURE AND PROCESS FOR FORMING SAME

The present invention is directed to an intermediate manufacturing semiconductor device structure and a process for forming same. More specifically, the instant invention is directed to a metallic electrical contact disposed on a semiconductor device covered by an insulator and a method for forming same.

The inclusion of an electrical contact between a source of electrical power and a semiconductor device is obviously a critical step in the manufacture of a semiconductor device. In the prior art an electrically conducting metal was disposed on a surface of the semiconductor device to provide such electrical communication. Although the methods of the prior art suffice to produce acceptable semiconductor electrical connections, certain problems associated with these prior art devices and methods for their formation have led investigators to seek new and better means of providing this electrical contact.

A major problem associated with the prior art method of affixing a metal electrical contact onto a semiconductor surface lies in the poor surface morphology of the semiconductor device upon which the metal electrical communication means is disposed. Those skilled in the art of semiconductor processing techniques are aware of the reasons for this surface damage. Usually, an anisotropic dry etching technique, for example, reactive ion etching, is utilized in preparing surfaces of semiconductor devices prior to positioning of the electrical conducting contact onto the semiconductor device. Unfortunately, anisotropic etching can, and oftentime does, damage the surface of the semiconductor device over which a metal conducting material is to be disposed. This poor surface morphology results in leaky barriers and spurious resistance in contacts in semiconductor devices. Consequently, the electrical potential supplied by the electrical source does not reach the transistor device at the desired level. Thus, this problem of surface damage is a major culprit in the production of defective semiconductor devices. A paper, co-authored by one of the inventors of the present application, G. S. Oehrlein et al., J. Electrochemical Soc. 132, 1441 (1985) summarizes the surface damage problems associated with dry etching treatments of semiconductor devices.

An example of metal electrical conducting contacts affixed to semiconductor devices is provided in U.S. Patent 3,431,472. The ' 472 patent discloses Ohmic contacts to a silicon body semiconductor device. This device includes palladium metal electrical contacts deposited on a silicon wafer. In devices of this design the problem, described above, lies in poor electrical communication between the metal contact and the silicon wafer caused by damage to the surface of the silicon upon which the metal, in this case palladium, is disposed.

The disposition of metals by ion sputtering techniques onto semiconductor devices is well known in the art. U.S. Patent 4,377,734, for example, teaches such a method. That the metal implanted in this procedure forms silicides by solid phase reaction between the silicon substrate and the thin metal film deposited thereon is also known in the art. P. Joubert et al., J. Appl. Phys. 56, 2734 (1984) addresses this phenomenon in detail. A similar procedure involving improvement in Schottky barrier diode characteristics is provided by D. F. Baron et al., IBM Techn. Disc. Bull. 28, 2093 (1985).

Although metal ion implantation techniques are known in the art, these techniques do not provide self-alignment. The siting of metal ions at the desired location on a silicon wafer is critical. Ion sputtering of a metal onto a silicon wafer must be designed so that the metal is implanted in the exact location necessary to provide proper electrical communication without adversely affecting the electrical circuit or circuits imposed on the surface of the wafer.

The above remarks establish the need in the art to provide better Ohmic and Schottky contacts, as these metal contacts are known in the semiconductor art, on transistor devices. In addition, the process of aligning the metal contact on the surface of semiconductor devices is in need of improvement.

The invention as claimed solves the above-mentioned problems, i. e. considerably decreases the problems associated with poor contact between a silicon semiconductor device and a metal contact while at the same time providing excellent alignment of such metal contact.

To summarize, a process is provided for fabricating an electronic device structure from a silicon semiconductor crystal. The silicon semiconductor crystal is provided with at least one surface of an electrically insulating silicon-containing compound which is partially masked. This surface is subjected to metal ion implantation. Ions of palladium, platinum, nickel, cobalt, ruthenium, rhodium or copper may be used in this implantation step. As a result of ion implantation, a layer of one of the above-recited metals is disposed below the unmasked surfaces of the silicon-containing compound at the interface between the inert silicon-containing compound layer and the silicon monocrystalline substrate. The semiconductor device structure is then heated to a temperature in the range of between about 100 °C and 500 °C effecting the formation of the silicide of the metal ion implanted into the semiconductor. Finally, the so-treated device structure is exposed to an anisotropic dry etching procedure whereby the unmasked inert silicon-containing compound layer, disposed above the metal silicide, is removed.

In a further aspect an intermediate manufacturing semiconductor product is provided. The semiconductor product comprises a monocrystalline silicon substrate having at least one surface characterized by an unmasked metal silicide layer and a masked electrical insulating silicon-containing compound layer.

The instant invention may be better understood with reference to the accompanying drawings of which:

Figure 1 is a schematic representation of a masked silicon semiconductor device structure provided with an electrical insulating silicon-containing compound surface;

Figure 2 is a schematic representation of the same device structure after the metal implantation and heating steps of the present invention;

Figure 3 is a schematic representation of the same device structure immediately after being subjected to the anisotropic dry etching step of the instant invention;

Figure 4 is a schematic representation of a field effect transistor made from the internmediate device structure of Figure 3;

Figure 5 is a schematic representation of a bipolar transistor made from the intermediate device structure of Figure 3; and

Figure 6 is a schematic representation of a planar diode made from the intermediate device structure of Figure 3.

The process of the present invention provides an electrical contact at the exact desired location on the surface of a monocrystalline silicon semiconductor device in the substantial absence of poor morphology of the silicon surface upon which the electrical contact is disposed. This contact is provided beneath an insulating layer of an electrically insulating silicon-containing compound which may subsequently be removed from the contact area.

In the process of this invention a silicon semiconductor device structure, which eventually may be fabricated into a field effect transistor, a bipolar transistor or a planar diode, whose surface is masked in part with a photoresist covering those portions of a silicon-containing insulating surface, where such an insulating covering is desired in the final device, is exposed to a metal ion implantation step. The metal ion implantation step involves the disposition of metal ions at the interface between the inert silicon-containing compound layer and the silicon monocrystalline body of the semiconductor device under the unmasked portions of the semiconductor surface.

This procedure, which occurs at substantially ambient temperature, represents an advance in the prior art over the metal ion implantation techniques of the prior art. This is so because the metallurgy formed by the subsequent reaction with unoxidized silicon is smooth and the underlining silicon is free of damage concomitant with dry etching. Unlike the procedures of the prior art, wherein patterning is required to dispose the metal ions on the desired position of the base semiconductor surface, the present procedure automatically self-aligns metal ions in the desired position and protects the remaining semiconductor from etching damage. The self-alignment occurs because the masked portions of the surface prevent penetration of the metal ions into the semiconductor. Disposition of the metal ions is limited to those portions of the monocrystalline silicon substrate to which electrical communication is desired, with no metal disposed under insulated surfaces of the transistor device. Further, the subsequently formed silicide metallurgy protects the semiconductor under it from damage during the etching process.

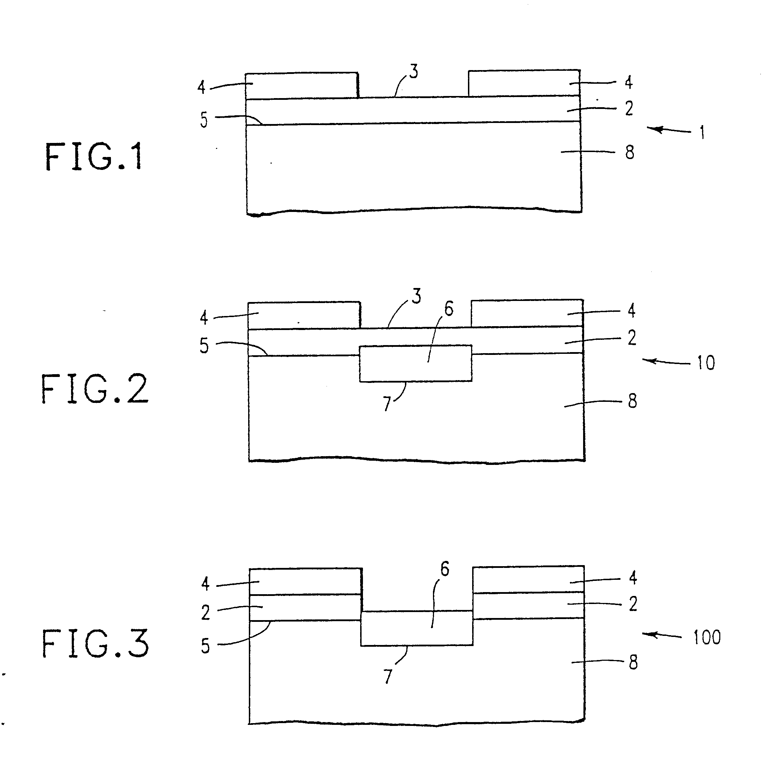

To better appreciate the above remarks, attention is directed to the drawings. The silicon semiconductor device, generally indicated at 1, is depicted in Figure 1 as an intermediate production conventional semiconductor device. That is, the surface is a thin layer 2 of an electrical insulating silicon-containing compound.

In one preferred embodiment this surface is merely oxidized to provide a thin layer of electrical insulating silicon dioxide. In another preferred embodiment, the electrical insulating silicon-containing compound is silicon nitride. Although both of these silicon-containing compounds are preferred, silicon dioxide is more oftentimes utilized. Therefore, the following discussion will refer to the electrical insulating layer as silicon dioxide. It is, of course, to be appreciated that the recitation of silicon dioxide hereinafter should be interpreted as including other silicon-containing electrical insulating compounds, especially silicon nitride.

Those portions of the surface 3 of the layer 2 that are ultimately to remain insulated, that is, to retain a silicon dioxide layer, are masked with a photoresist 4. The photoresist mask or masks 4, as those skilled in the art are aware, mask surfaces from the effect of anisotropic dry etching. Thus, the masked surface is unaffected by dry erosion techniques. However, the photoresist mask 4 not only masks the silicon device 1 from reactive ion etching or reactive ion beam etching but, in addition, masks the device 1 from the effects of a metal ion beam. As a result, only that portion of the device 1 not covered by one or more photoresist masks 4 are penetrated with metal ions during the metal ion implantation step.

The device 1 depicted in Figure 1 is subjected to a metal ion implantation procedure. This procedure is conventional in the art. For example, The Physics of Microfabrication, by Brodie and Muray, p. 45, Plenum Press, New York (1982) and G.K. Hubler et al., Corrosion Sci. 20, 103 (1980) describe such procedures in detail.

The ions implanted into the device 1 of the present invention are ions of a metal selected from the group consisting of palladium, platinum, nickel, cobalt, ruthenium, rhodium and copper. More preferably, the metal whose ions are implanted into the device 1 of the present invention is selected from the group consisting of palladium, plantium and nickel. Most preferably, the metal whose ions are utilized in the present invention is palladium.

After the metal ion implantation step is completed, the device 1 is possessed of a metal layer lodged at the interface 5 between the silicon dioxide layer 2 and a monocrystalline silicon substrate 8. The device, at this point, is subjected to a heating step. Although the invention is independent of any theory explaining its mechanism, it is postulated that the heating step causes the silicon or the metal ions to migrate and thus contact each other. Upon contact the silicon and metal react in the solid state to form a metal silicide. Whether the silicon or the metal ions migrate is a particular function of the metal utilized. For example, in the preferred embodiment wherein palladium ions are utilized, it is generally agreed in the art that it is the palladium ions that migrate to the silicon.

The heating step occurs at a temperature in the range of between about 100 °C and 500 °C. Those skilled in the art are aware that the temperature selected is a function of the metal utilized in the ion implantation step. That is, the earlier described theory of the criticality of the migration step establishes that it is the temperature at which the metal or the silicon migrates that is critical in the formation of the metal silicide. That is, it is the lower of the migration temperature of the metal or silicon that determines the minimum temperature of the heating step. Since many metals may be employed in the present invention, the heating step may occur over a relative wide temperature range. It is noted in passing that the temperature of reaction between the metal and the silicon is not theorized to be critical. It is concluded that the solid state reaction of metal and silicon occurs relatively rapidly as soon as contact between the species is made. Thus, the criticality of the migration step.

Neither silicon nor any of the metals within the contemplation of the present invention migrates at a temperature below 100 °C. Furthermore, neither the metals within the contemplation of the present invention nor silicon requires a temperature in excess of 500 °C to migrate.

It should be appreciated that the heating step must occur at a temperature consistent with the maintenance of the photoresist mask. That is, the temperature of the heating step must not be so high as to have a deleterious effect on the photoresist mask. Although, photoresists of differing composition are known in the art, which have differing temperatures above which they lose their effectiveness, none are presently available which remain stable over 500 °C.

The above remarks establish that the heating step of the process of the present invention occurs at a temperature in the range of between about 100 °C and 500 °C. Preferably, the heating step occurs at a temperature in the range of between about 125 °C and 450 °C. More preferably, the heating step occurs at a temperature in the range of between about 150 °C and 400 °C. Still more preferably, the heating step takes place at a temperature in the range of between about 175 °C and 350 °C.

In the preferred embodiment of the process of the present invention wherein palladium is utilized as the metal, it is especially preferred that the heating step occur at a temperature in the range of between about 175 °C and 300 °C. Even more preferably, when palladium is employed as the metal, the heating step occurs at a temperature in the range of between about 190 °C and 250 °C. Most preferably, the heating step of the palladium included transistor device occurs at approximately 200 °C.

After the metal ion implantation and heating steps, the semiconductor device takes on the appearance depicted in Figure 2. Because the device of Figure 2 is distinguished from the device 1, it is designated therein by reference numeral 10. As shown therein, a layer of the metal silicide 6 is lodged at the interface 5 partially in the silicon dioxide layer 2 and partially in the silicon monocrystalline substrate 8. It is also emphasized that the metal silicide layer 6 is self-aligned. That is, the layer 6 is vertically disposed beneath only unmasked portions of the surface 3 of the silicon dioxide layer 2.

In the final step of the process of the present invention, the device is subjected to an anisotropic dry etching step. Those skilled in the art are aware that this procedure, which may be reactive ion etching or reactive ion beam etching, is one in which a semiconductor device, such as device 10, is exposed to radiation plasma of an etching element, preferably a halogen, more preferably, fluorine or chlorine and most preferably, fluorine. This etching step results in the removal of the unmasked silicon dioxide surface layer. Obviously, those portions of the surface masked by the photoresist 4 are protected from the effect of the etching beam and remain unchanged. The condition of the device after the anisotropic dry etching step, now changed and thus newly designated by reference numeral 100, is shown in Figure 3. Unlike the process of the prior art, wherein the silicon monocrystalline substrate 8 is subjected to radiation damage resulting in poor surface morphology and ultimate semiconductor failure, as discussed earlier, the metal silicide layer 6, upon removal by etching of the silicon dioxide layer 2, disposed over the metal silicide layer 6, absorbs the radiation directed at its surface during anisotropic dry etching. This substantially eliminates the surface problem of the prior art. It is also noted that the loss of dopants in the silicon crystal 8, which occurs in the prior art when radiation attacks the surface of a silicon substrate, is eliminated by the metal silicide surface.

The resultant intermediate manufacturing product produced after subjection of the device 10 to anisotropic dry etching is the device designated by reference numeral 100. The intermediate manufacturing product 100, as shown in Figure 3, is characterized by a surface comprising a masked region, wherein a photoresist 4 sits atop a silicon dioxide layer 2, and an unmasked metal silicide region 6. The contact 7 between the metal silicide and the silicon substrate is obviously free of surface defects. The surface is aligned such that there is no overlap between the silicon dioxide layer 2 and the metal silicide layer 6 because of the self-alignment effect of the process of the present invention as described herein earlier.

The depiction in Figure 3 is a convenient way of turning to the product of the present invention. The product of the present invention is an intermediate manufacturing device later to be formed into a field effect transistor, a bipolar transistor or a planar diode. It is characterized by at least one surface being covered with a masked silicon dioxide layer and an unmasked metal silicide layer.

The metal silicide region of at least one surface of the intermediate product of this invention is palladium silicide, platinum silicide, nickel silicide, cobalt silicide, ruthenium silicide, rhodium silicide or copper silicide. More preferably, the metal silicide is palladium silicide, platinum silicide or nickel silicide. Most preferably, the metal silicide is palladium silicide.

A preferred aspect of the intermediate manufacturing product of the present invention is the self-alignment of the masked silicon dioxide regions. That is, metal silicide 6 completely covers the surface other than those parts of the surface covered by the masked silicon dioxide layer 2.

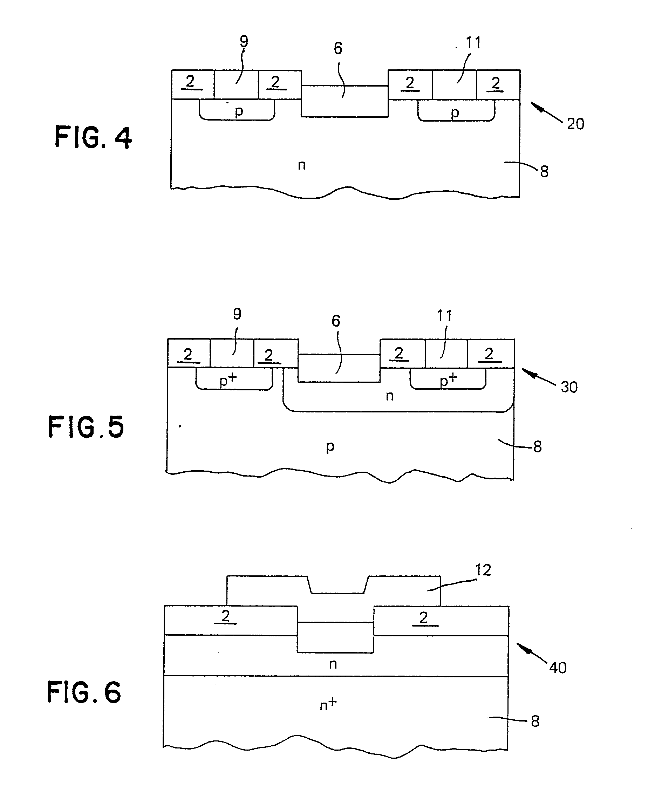

A field effect transistor 20 formed from intermediate device structure 100 is depicted in Figure 4. In this modification, a source electrical contact 9 of a suitable electrical conductor is implanted in the silicon dioxide layer 2. Similarly, a drain electrical contact 11 of a suitable electrical conductor is also implanted in the silicon dioxide layer 2. This is accomplished by methods well known in the art. The silicon crystal 8 under contacts 9 and 11 are doped positive while the remainder of the silicon crystal 8 is doped negative by standard processing techniques well known in the transistor art. These dopings of crystal 8 are denoted as p and n, respectively, in Figure 4. The gate electrode is the metal silicide layer 6.

A bipolar transistor 30 fabricated from intermediate device structure 100 is illustrated in Figure 5. As in the case of transistor 20, source and drain electrical contacts 9 and 11 are implanted in the silicon dioxide layer 2. Again, the gate contact is provided by the metal silicide layer 6. The bipolar transistor is formed by doping techniques well known in the art. Illustrative of the doping techniques, the silicon crystal 8 is doped such that the silicon in electrical communication with the source and drain electrical contacts 9 and 11 is heavily positive, denoted as $p^+$. As is standard in bipolar transistors, negative doping, denoted n, surrounds the gate 6 and heavily positive portions of the silicon crystal surrounding the drain contact 11. A positive doping is in contact with the negative doped portions of the crystal 8 as well as the heavily positive doped portion of the crystal surrounding the source contact 9.

Figure 6 is illustrative of a planar diode, denoted at 40, formed from the intermediate device structure 100. The diode 40 includes an aluminum electrode 12 formed on metal silicide layer 6. The crystal 8 is doped negative, denoted n, and strongly negative, shown in the Figure 6 as $n^+$, in accordance with the techniques used in the standard design of planar diodes.

The above description will make apparent to those skilled in the art examples and embodiments thereof. These examples and embodiments are within the contemplation of the present invention. Therefore, the present invention should be limited only by the appended claims.

**Claims**

1. A process for fabricating an electronic device structure from a silicon semiconductor crystal, said crystal provided with at least one electrical insulating silicon-containing compound surface, comprising:

masking portions of an electrical insulating silicon-compound surface layer (2) of a silicon semiconductor crystal (8) (Fig. 1);

subjecting said silicon-containing surface layer (2) to metal ion implantation, said metal selected from the group consisting of palladium, platinum, nickel, cobalt, ruthenium, rhodium and copper, whereby a layer of metal (6) is disposed below unmasked silicon-containing compound surfaces (3) at the interface (5) between said silicon-containing compound layer (2) and said silicon monocrystalline substrate (8) (Fig. 2);

heating said metal containing silicon semiconductor crystal to a temperature in the range of between about 100 °C and 500 °C whereby said metal reacts with said silicon substrate to form a metal silicide layer at the interface of said silicon-containing compound layer and said silicon monocrystalline substrate; and

anisotropically dry etching said surface (3) whereby said unmasked silicon-containing compound layer (2) disposed above said metal silicide layer (6) is removed.

2. The process in accordance with claim 1 wherein said electrical insulating silicon-containing compound is silicon dioxide.

3. The process in accordance with claims 1 or 2 wherein said electrical insulating silicon-containing compound includes silicon nitride.

4. The process in accordance with one of the preceding claims wherein said metal silicide layer (6) is formed below the entire unmasked insulating silicon-containing compound layer (2).

5. The process in accordance with one of the preceding claims wherein said ions implanted into said silicon semiconductor crystal (8) are ions of a metal selected from the group consisting of palladium, platinum, nickel, cobalt, ruthenium and rhodium and preferably selected from the group consisting of palladium, platinum and nickel.

6. The process in accordance with one of the preceding claims wherein said heating step occurs at a temperature in the range of between about 125 °C and 450 °C and most preferably in the range of between about 175 °C and 350 °C.

7. The process in accordance with one of the preceding claims wherein a silicon dioxide surface is subjected to palladium implantation and said heating step is carried out at a temperature in the range of between about 175 °C and 300 °C, preferably at a temperature of about 200 °C.

8. An intermediate manufacturing product structure comprising a silicon semiconductor crystal (8) provided with at least one surface which includes a masked electrical insulating silicon-containing compound layer (2) and an unmasked metal silicide layer (6).

9. The structure in accordance with claim 8 wherein said surface is completely covered with said masked silicon-containing compound layer and said unmasked metal silicide layer.

10. The structure in accordance with claims 8 or 9 wherein said intermediate manufacturing product is adapted for fabrication into a field effect transistor or into a planar diode.

11. The structure in accordance with one of claims 8 to 10 wherein said metal of said metal silicide is selected from the group consisting of palladium, platinum, nickel, cobalt, ruthenium, rhodium and copper.

12. The structure in accordance with one of claims 8 to 11 wherein said electrical insulating silicon-containing compound is silicon dioxide or silicon nitride.

FIG.1

FIG.2

FIG.3

FIG. 4

FIG. 5

FIG. 6

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | US-A-4 096 622  (GENERAL MOTORS CORP.) * Column 4, line 65 - column 5, line 63; column 3, lines 57-60 * | 1,2,4,8,9 | H 01 L  21/285 H 01 L  21/265 |
| A | | 7,10-12 | |
| Y | | 5,6 | |
| A | EP-A-0 128 385  (HITACHI) * Claim 1; page 13, lines 17-22; page 4, lines 4-7 * | 1,6,8-10 | |
| A | SOLID STATE TECHNOLOGY, vol. 17, no. 11, November 1974, pages 36-46, Port Washington, US; A. AXMANN: "Ionizable materials to produce ions for implantation" * Table I * | 1,5,11 | |
| A | CHEMICAL ABSTRACTS, vol. 81, no. 26, 30th December 1974, page 634, abstract no. 178786w, Columbus, Ohio, US; H. KRAENTLE et al.: "Ion-implanted silicon-metal systems Si1-xMx", & ION IMPLANTATION SEMICOND. OTHER MATER., PR. INT. CONF., 3rd 1972 (Pub. 1973), 585-96 * Whole abstract * | 1,5,11 | |
| A | EP-A-0 134 166  (FAIRCHILD CAMERA & INSTRUMENT CORP.) * Claim 1 * | 3 | |
| Y | US-A-3 968 272  (MICROWAVE ASSOCIATES INC.) * Claims 1,3 * | 5,6 | |
| A | | 1 | |

TECHNICAL FIELDS SEARCHED (Int. Cl.4)

H 01 L

---  -/-

The present search report has been drawn up for all claims

| Place of search | Date of completion of the search | Examiner |
|---|---|---|
| THE HAGUE | 14-12-1987 | PHEASANT N.J. |

European Patent
Office

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (Int. Cl. 4) |
|---|---|---|---|
| A | GB-A-2 149 206  (INMOS CORP.)<br>----- | | |

TECHNICAL FIELDS
SEARCHED (Int. Cl.4)

The present search report has been drawn up for all claims

| Place of search | Date of completion of the search | Examiner |
|---|---|---|
| THE HAGUE | 14-12-1987 | PHEASANT N.J. |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P0401)